# EUROPEAN PATENT SPECIFICATION

(11) **EP 4 137 618 B1**
(45) Date of publication and mention of the grant of the patent: **06.12.2023**
(21) Application number: 22180299.4
(22) Date of filing: 22.06.2022
(51) Int. Cl.: B23K 1/06, C30B 29/06, C30B 33/06, B23K 1/19

(54) **METHOD OF BONDING SILICON PARTS USING SILICON POWDER AND HIGH-FREQUENCY HEATING DEVICE**
VERFAHREN ZUM VERBINDEN VON SILIZIUMBAUTEILEN MIT SILIZIUMPULVER UND EINER HOCHFREQUENZHEIZVORRICHTUNG
PROCÉDÉ DE COLLAGE DE PIÈCES EN SILICIUM À L'AIDE DE POUDRE DE SILICIUM ET D'UN DISPOSITIF DE CHAUFFAGE HAUTE FRÉQUENCE

(30) Priority: 18.08.2021 KR 20210108822
(43) Date of publication of application: 22.02.2023
(73) Proprietor: Lintech Corporation, Gyeonggi-do (KR)
(72) Inventor: YOU, HO JUNG, Incheon (KR); SHIN, DONG NAM, Gyeonggi-do (KR); OH, SEI KWANG, Gyeonggi-do (KR); SHIN, YEONG BEOM, Seoul (KR); KANG, TAE-WOO, Gyeonggi-do (KR)
(74) Representative: Tetzner, Michael

(56) References cited:
- KR-A- 20160 001 838
- KR-B1- 102 102 132
- US-A1- 2012 000 608

## Description

### BACKGROUND OF THE INVENTION

### Cross Reference to Related Application of the Invention

The present application claims the benefit of Korean Patent Application No. 10-2021-0108822 filed in the Korean Intellectual Property Office on August 18, 2021.

### Field of the Invention

The present invention relates to a method of bonding silicon parts using silicon powder and high-frequency heating device.

### Background of the Related Art

Generally, a semiconductor device is made by forming a semiconductive thin film, a conductive thin film, or an insulating thin film on a semiconductor substrate (that is, a silicon wafer) and then etching a portion of the thin film.

In the processes of forming the thin film and etching the thin film, plasma technology is used. In the etching process, for example, a reaction gas is supplied to a plasma etching chamber, and then, high-frequency power is applied to the chamber, thereby causing a plasma state where the reaction gas is excited.

To improve etching and film deposition efficiencies, a variety of silicon parts are adopted in the chamber used for the processes of forming the thin film and etching the thin film in the semiconductor manufacturing process, so that they serve to support the wafer, uniformly distribute the plasma, introduce the gas flowing in the chamber, and exhaust the introduced gas.

As one of the silicon parts, a confinement ring (hereinafter referred to as "C-ring") is disclosed in Korean Utility Model Registration No. 20-0478935, which is a consumable silicon part and needs high-priced equipment such as a laser and advanced technologies such as electric discharging, upon slot machining. In a state where a slot machining portion floats in the air, there is no separate fixing device for the C-ring, thereby making it hard to stably fix the C-ring. In case of silicon having strong brittleness, therefore, slots may be easily broken, thereby causing a low machining yield and a large amount of material loss.

To solve such problems, methods for manufacturing a C-ring constituted of an upper ring and a lower ring separated from each other through a third connection part or screw-bonding for bonding the upper ring and the lower ring to each other, are disclosed in Korean Patent No. 10-2102132 and No. 10-2040281, and Korean Utility Model Registration No. 20-0491165.

However, the conventional technologies are complicated in structure and generate particles from the bonding portion between the respective parts, thereby making qualities of etching and film deposition deteriorated badly.

### SUMMARY OF THE INVENTION

Accordingly, the present invention has been made in view of the above-mentioned problems occurring in the related art, and it is an object of the present invention to provide a method of bonding silicon parts using silicon powder and high-frequency heating device that is capable of fusedly bonding the silicon parts to each other by using the silicon powder and the high-frequency heaters, thereby providing a simple bonding configuration and improving qualities of etching and film deposition.

To accomplish the above-mentioned objects, according to the present invention, there is provided a method for fusedly bonding silicon parts to each other, the method including the steps of: forming concave and convex coupling surfaces on the bonding surfaces of a lower ring and an upper ring; mounting the lower ring and the upper ring on a silicon part fusion bonding apparatus; injecting single crystal silicon powder into the concave and convex coupling surfaces on the bonding surfaces of the lower ring and the upper ring; and heating and fusing the bonding surfaces of the lower ring and the upper ring.

According to the present invention, desirably, the step of forming the concave and convex coupling surfaces as the bonding surfaces of the lower ring and the upper ring may be carried out by forming a protrusion protruding from the underside of the upper ring and a concave groove on top of the lower ring in such a manner as to be coupled to the protrusion of the upper ring.

According to the present invention, desirably, the concave groove may be symmetrically formed around a central circumferential line on top of the lower ring and has the shape of a circular groove formed over the entire width of top of the lower ring.

According to the present invention, desirably, a distance to the deepest portion of the concave groove from top of the lower ring may be 3 to 5 mm, and a length of the deepest portion of the concave groove along the width direction of top of the lower ring may be within 70% of the entire width of top of the lower ring.

According to the present invention, desirably, the upper ring may have an upper positioning protrusion protruding from the underside thereof, and the lower ring has a lower positioning groove formed on a given portion of top thereof in such a manner as to be coupled to the upper positioning protrusion of the upper ring, the lower positioning groove being formed between an outer center line between the central circumferential line and an outer circumferential line of the lower ring and the outer circumferential line of the lower ring or being formed between an inner center line between the central circumferential line and an inner circumferential line of the lower ring and the inner circumferential line of the lower ring.

According to the present invention, desirably, the lower positioning groove may be a hemispherical groove.

According to the present invention, desirably, after the silicon powder as a fusing agent is filled in a fusion portion between the lower ring and the upper ring, the lower ring and the upper ring are mounted on a lower ring fixing device made of molybdenum and an upper ring fixing device made of molybdenum in the silicon part fusion bonding apparatus, respectively.

According to the present invention, desirably, the step of heating and fusing the bonding surface of the lower ring and the upper ring may include the steps of: forming a vacuum atmosphere of 90 to 110 torr; injecting argon gas to maintain a vacuum level of 50 to 70 torr; applying a given pressure to a space between the lower ring and the upper ring by means of the lower ring fixing device and the upper ring fixing device; operating upper heaters and lower heaters to increase an atmospheric temperature of a vacuum furnace in which a crucible is mounted; operating side heaters capable of performing high-frequency induction heating to locally heat the fusion portion of the bonding surfaces; and cooling the fusion portion.

According to the present invention, desirably, a fusing temperature of the fusion portion through the operation of the side heaters capable of performing the high-frequency induction heating is in the range of 1500 to 1600°C.

According to the present invention, desirably, the step of cooling the fusion portion is carried out by turning off the side heaters capable of performing the high-frequency induction heating after the fusion portion has been fused and step by step decreasing the temperatures of the upper heaters and the lower heaters to 1400°C, 1200°C, 1000°C, 900°C, 700°C, 500°C, and 300°C, while the temperature by the respective step being maintained for 10 to 20 minutes.

### BRIEF DESCRIPTION OF THE DRAWINGS

The above and other objects, features and advantages of the present invention will be apparent from the following detailed description of the embodiments of the invention in conjunction with the accompanying drawings, in which:
FIG. 1 is a sectional view showing a silicon part fusion bonding apparatus using silicon powder and high-frequency heaters according to the present invention;
FIG. 2 is a perspective view showing a C-ring as one example of the silicon part according to the present invention;
FIG. 3 is a cutaway sectional view showing an example of concave and convex coupling surfaces as the bonding surfaces of lower and upper rings of the C-ring of FIG. 2; and
FIG. 4 is a cutaway sectional view showing another example of the concave and convex coupling surfaces as the bonding surfaces of the lower and upper rings of the C-ring of FIG. 2.

### DETAILED DESCRIPTION OF THE EMBODIMENTS

Hereinafter, an explanation of a method for fusedly bonding silicon parts using silicon powder and high-frequency heaters according to the present invention will be given in detail with reference to the attached drawings.

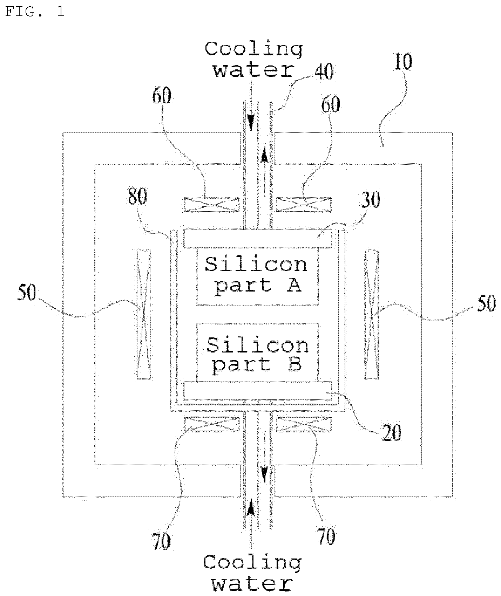

Generally, a silicon part is used in an etching device when a semiconductor is manufactured in a plasma processing chamber, and the silicon part is made of any one material selected from the group consisting of single crystal silicon (mono c-Si), polycrystalline silicon (poly c-Si), sapphire, Y203, SiC, Quartz, Si₃N₄, and ZrO₂. The silicon part represents a consumable part such as the C-ring constituting a plasma processing chamber of FIG.1 as disclosed in Korean Utility Model Registration No. 20-0478935.

For the brevity of the description, hereinafter, a method for fusedly bonding C-rings according to the present invention will be explained, but the silicon parts used in the present invention are not limited only to the C-rings. Further, it is obvious that equipment where the silicon parts are used is not limited only to the plasma processing chamber.

First, a silicon part fusion bonding apparatus using silicon powder and high-frequency heaters according to the present invention is modifiedly provided as very similar equipment to a silicon ingot manufacturing apparatus for producing a silicon ingot in the same technical field as the present invention, which is disclosed in Korean Patent No. 10-0916843 and Korean Patent Application Laid-open No. 10-2011-0038040. Further, the present invention may utilize the technologies related to heaters, coolers, control of the heaters and the coolers, a structure of fixing a crucible, and the like that are applied to the above-mentioned conventional technologies, but for the brevity of the description, detailed explanations of the technologies will be avoided.

To allow the present invention to be easily understood, however, a whole configuration of the silicon part fusion bonding apparatus using silicon powder and high-frequency heaters according to the present invention is shown in FIG. 1.

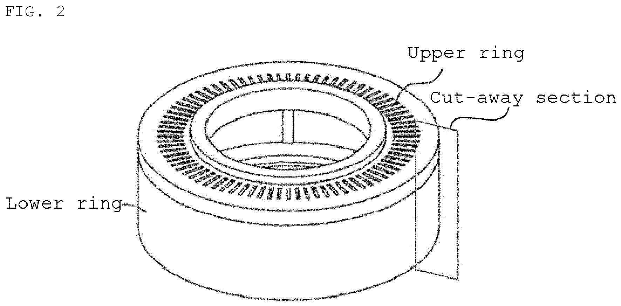

As shown in FIG. 1, a vacuum furnace 10 includes a crucible 80 for ensuring a space in which a silicon part A (corresponding to an upper ring of a C-ring as an exemplary part of FIG. 2) and a silicon part B (corresponding to a lower ring of the C-ring as the exemplary part of FIG. 2) to be coupled to each other are accommodated, side heaters 50 for heating the silicon part A and the silicon part B through high-frequency induction heating, water cooled upper heaters 60 using resistance heating, water cooled lower heaters 70 using resistance heating, a lower ring fixing device 20 made of molybdenum to fixedly mount the silicon part B, and an upper ring fixing device 30 made of molybdenum and moving up and down to fixedly mount the silicon part A and thus pressurize the silicon part A.

The water cooled upper heaters 60 using the resistance heating may be configured as resistance heating wires such as carbon resistance heaters, which are buried in the upper ring fixing device 30 that is made of molybdenum and moves up and down to fixedly mount the silicon part A and thus pressurize the silicon part A, and the water cooled lower heaters 70 using the resistance heating may be configured as resistance heating wires such as carbon resistance heaters, which are buried in the lower ring fixing device 20 that is made of molybdenum to fixedly mount the silicon part B.

Moreover, a heating device, a pump for supplying cooling water, a vacuum maintaining device, a temperature control device, an argon (Ar) atmosphere maintaining and gas introducing and exhausting device, and the like that are used in a silicon ingot manufacturing apparatus or an etching and film deposition apparatus may be additionally provided even though not shown.

A method for fusedly bonding silicon parts using silicon powder and high-frequency heaters according to the present invention will be explained below (See Korean Patent Application Laid-open No. 10-2016-0001838).

For the conveniences of the description, hereinafter, it is assumed that the upper ring of the C-ring as one of the silicon parts is the silicon part A and the lower ring thereof is the silicon part B. In specific, a part where slits are formed on the C-ring is called the upper ring for the conveniences of the description, but of course, the part may be called the lower ring.

The method for fusedly bonding silicon parts using silicon powder and high-frequency heaters according to the present invention includes the step of making an upper ring.

At the step of making the upper ring, a C-ring as disclosed in Korean Utility Model Registration No. 20-0478935 or a silicon disc cut off through a sawing process as disclosed in Korean Patent No. 10-2102132 is prepared.

Next, a core drilling (or coring) process is performed to form a silicon ring body on which a through hole is formed on the silicon disc.

Further, the silicon ring body with the coring process is machined in inner and outer circumferential surfaces by means of a grinding machine or machining center tool (MCT), and additional processes for the silicon ring body are performed by means of a silicon part machining method for forming various holes thereon with an electrical discharge machine.

Next, the method for fusedly bonding silicon parts according to the present invention includes the step of making a lower ring.

At the step of making the lower ring, the lower ring is made through the method for manufacturing the C-ring as disclosed in Korean Utility Model Registration No. 20-0478935 or the C-ring as disclosed in Korean Patent No. 10-2102132.

In specific, a silicon disc cut off through a wire sawing process is prepared, and next, a core drilling (or coring) process is performed to form a silicon ring body on which a through hole is formed on the silicon disc.

Further, the silicon ring body with the coring process is machined in inner and outer circumferential surfaces by means of a grinding machine or MCT, and additional processes for the silicon ring body are performed by means of the silicon part machining method for forming various holes thereon with an electrical discharge machine.

Next, the method for fusedly bonding silicon parts according to the present invention includes the step of forming concave and convex coupling surfaces as the bonding surfaces of the upper ring and the lower ring. To do this, first, silicon powder is filled on top of the lower ring coming into contact with the upper ring, and a concave groove is then formed on top of the lower ring so that it is coupled to a protrusion as will be discussed later formed on the underside of the upper ring.

The concave groove is symmetrically formed around a central circumferential line (imaginary circumferential line) on top of the lower ring and is a circular groove formed over the entire top of the lower ring.

A size of the concave groove may change in accordance with the size and material of the C-ring. The vertical sectional shape of the lower ring is desirably 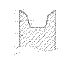 , but it is limited thereto.

Further, a distance to the deepest portion of the concave groove from top of the lower ring is 3 to 5 mm, and a length of the deepest portion of the concave groove along the width direction of top of the lower ring is desirably within 70% of the entire width of top of the lower ring.

Further, a lower positioning groove is formed close to the concave groove to allow the lower ring to be aligned with the upper ring when the lower ring is bonded to the upper ring.

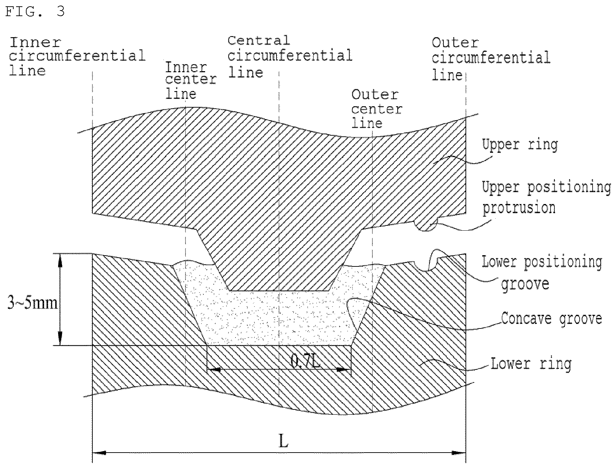

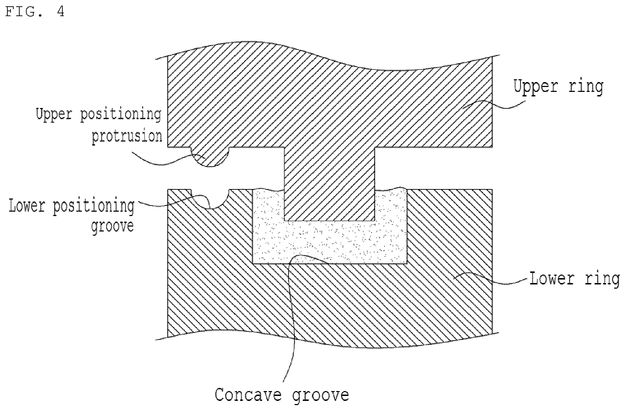

As shown in FIGs. 3 and 4, in specific, the upper ring has an upper positioning protrusion protruding from the underside thereof, and the lower ring has the lower positioning groove formed on a portion of top thereof in such a manner as to be coupled to the upper positioning protrusion of the upper ring. The lower positioning groove is formed between an outer center line between the central circumferential line and an outer circumferential line of the lower ring and the outer circumferential line of the lower ring, and otherwise, it may be formed between an inner center line between the central circumferential line and an inner circumferential line of the lower ring and the inner circumferential line of the lower ring.

One or two lower positioning grooves may be formed on the outer or inner side of top of the lower ring from the central circumferential line of top of the lower ring, and the position of the lower positioning groove is desirably at the intermediate point between the central circumferential line and the outer circumferential line of top of the lower ring or at the intermediate point between the central circumferential line and the inner circumferential line of top of the lower ring.

Further, the lower positioning groove is a hemispherical groove having a maximum protruding height of 1 mm and a maximum diameter of 1 mm.

Further, the lower positioning groove is machined by means of a grinding machine or MCT, and additional processes for the lower positioning groove are performed by means of electrical discharging or etching.

Next, the method for fusedly bonding silicon parts according to the present invention includes the step of mounting the lower ring and the upper ring on the silicon part fusion bonding apparatus as shown in FIG. 1.

After the silicon powder as a fusing agent is first filled in a fusion portion between the lower ring and the upper ring, however, the step of mounting the lower ring and the upper ring is carried out by mounting the lower ring and the upper ring on the lower ring fixing device 20 made of the molybdenum and the upper ring fixing device 30 made of the molybdenum of the silicon part fusion bonding apparatus, respectively.

Further, parts for mounting the upper ring and the lower ring on the upper ring fixing device 30 made of the molybdenum and the lower ring fixing device 20 made of the molybdenum, respectively are not shown, but machine part fixing devices utilized generally in the field of the present invention may be used as the mounting parts. Each mounting part may have the shape of a simple flat plate corresponding to the shape of each silicon part.

During the fusing process of the silicon parts, that is, only if the mounting parts serve to fix the silicon parts, they do not matter in structure.

Next, the method for fusedly bonding silicon parts according to the present invention includes the step of injecting single crystal silicon powder into the concave and convex coupling surfaces as the bonding surfaces of the lower ring and the upper ring, so that the single crystal silicon powder as a melting and bonding agent is fused between the concave and convex coupling surfaces as the bonding surfaces of the lower ring and the upper ring to fusedly bond the lower ring and the upper ring.

In this case, an amount of single crystal silicon powder injected may change in accordance with the sizes of the lower ring and the upper ring, but when the single crystal silicon powder is fused to couple the lower ring and the upper ring to each other, for example, a fusion thickness of the silicon powder is 70%, while a fusion thickness of the bonding surfaces of the upper ring and the lower ring is being 30%, so that a fusion portion of 3 mm is desirably formed, which is appropriate when considering mechanical strength or welded surface machining efficiency to be carried out later.

However, the size of the fusion portion may change in accordance with the sizes and material characteristics of the silicon parts and the shapes of the bonding surfaces, and therefore, it may not be limited to the above-mentioned size.

Next, the method for fusedly bonding silicon parts according to the present invention includes the step of mounting the upper ring and the lower ring on the silicon part fusion bonding apparatus to fusedly bond the upper ring and the lower ring by means of heating and cooling.

In specific, the step is divided into the following sub-steps.

At a first sub-step, the upper ring and the lower ring reach a vacuum atmosphere of 90 to 110 torr by means of a vacuum pump of the silicon part fusion bonding apparatus.

At a second sub-step, argon (Ar) gas is injected to maintain a vacuum atmosphere of 50 to 70 torr.

At a third sub-step, a pressure is applied to a space between the upper ring and the lower ring by means of the upper ring fixing device 30 and the lower ring fixing device 20.

The application of the pressure is because when the fusion portion is heated by the side heaters 50 capable of performing high-frequency induction heating and is then cooled, the silicon of the fusion portion may be expanded. Through the application of the pressure, therefore, the expansion of the silicon can be suppressed, and of course, the pressure size applied may change in accordance with a product size, especially, a thickness of a welded portion.

For example, if the C-rings are adopted and a thickness of the bonding surfaces is 6 to 7 mm, the pressure is 1 kg/cm², and if the silicon parts generally used in semiconductor equipment are adopted, the pressure applied is in the range of 0.5 to 5 kg/cm².

At a fourth sub-step, next, the upper heaters 60 and the lower heaters 70 operate to increase an atmospheric temperature of the vacuum furnace 10 in which the crucible 80 is mounted up to 1300°C.

In this case, if a thermal shock with a temperature of 300°C or more is applied momentarily to the silicon parts, the silicon parts may be cracked according to silicon material characteristics, and accordingly, after the upper heaters 60 and the lower heaters 70 as the internal atmospheric temperature heaters (carbon resistance heaters) at the vacuum atmosphere of 90 torr (to which Ar gas is constantly supplied to thus maintain the vacuum level) are raised up to 300°C and then kept at the temperature for 30 minutes. Next, they are step by step raised up to 1180°C and then kept at each raised temperature for 30 minutes.

In this case, the internal atmospheric temperature heaters are raised up to 1420°C to maintain the atmospheric temperature of the vacuum furnace 10 to 1300°C.

At a fifth sub-step, the side heaters 50 capable of performing the high-frequency induction heating operate to locally heat the fusion portion.

In specific, the side heaters 50 capable of performing the high-frequency induction heating operate to heat the fusion portion up to a temperature of 1550°C at which the fusing portion is fused. In this case, the heating temperature is step by step raised to prevent the thermal shock from occurring.

In this case, the heating temperature may change in accordance with the thicknesses and shapes of the silicon parts, but generally, the heating temperature is desirably in the range of 1500 to 1600°C, more desirably 1550°C.

If the heating temperature is less than 1500°C, the silicon powder is locally fused, thereby failing to bond the lower ring and the upper ring, and contrarily, if the heating temperature is greater than 1600°C, the fusing surface of the silicon parts may collapse.

At a sixth sub-step, lastly, the fusion portion is cooled. That is, the fusion portion is formed at the heating temperature of 1550°C, and next, the side heaters 50 capable of performing the high-frequency induction heating is turned off. After that, the upper heaters 60 and the lower heaters 70 are controlled to step by step decrease their temperature to the units of 1400°C, 1200°C, 1000°C, 900°C, 700°C, 500°C, 300°C, and 100°C and then maintain the temperature by the respective step for 10 to 20 minutes.

If the temperatures of the upper heaters 60 and the lower heaters 70 are decreased up to 300°C, the upper heaters 60 and the lower heaters 70 are turned off.

Until the temperatures of the upper heaters 60 and the lower heaters 70 are decreased up to 100°C from 300°C, the fusion portion is naturally cooled to a temperature of 100°C or less by means of the Ar gas, thereby finishing the fusion bonding of the silicon parts.

After that, a machining flattening process for the fusion surface is carried out, but since the process is a typical process, a detailed explanation of the process will be avoided.

As described above, the method for fusedly bonding the silicon parts to each other according to the present invention includes the steps of forming the concave and convex coupling surfaces on the bonding surfaces of the lower ring and the upper ring, mounting the lower ring and the upper ring on a silicon part fusion bonding apparatus, injecting the single crystal silicon powder into the concave and convex coupling surfaces on the bonding surfaces of the lower ring and the upper ring, and heating and fusing the bonding surfaces of the lower ring and the upper ring, whereby through the simple configuration, qualities of etching and film deposition can be improved.

The embodiments of the present invention have been disclosed in the specification and drawings. In the description of the present invention, special terms are used not to limit the present invention and the scope of the present invention as defined in claims, but just to explain the present invention. Therefore, persons skilled in the relevant art can appreciate that many modifications and variations are possible in light of the above teachings. It is therefore intended that the scope of the invention be limited not by this detailed description, but the claims appended hereto.

## Claims

1. A method of bonding silicon parts using silicon powder and high-frequency heating device, the method comprising the steps of:
forming concave and convex coupling surfaces on the bonding surfaces of a lower ring and an upper ring;
mounting the lower ring and the upper ring on a silicon part fusion bonding apparatus;
injecting single crystal silicon powder into the concave and convex coupling surfaces on the bonding surfaces of the lower ring and the upper ring; and
heating and fusing the bonding surfaces of the lower ring and the upper ring.

2. The method according to claim 1, wherein the step of forming the concave and convex coupling surfaces on the bonding surfaces of the lower ring and the upper ring is carried out by forming a protrusion protruding from the underside of the upper ring and a concave groove on top of the lower ring in such a manner as to be coupled to the protrusion of the upper ring.

3. The method according to claim 2, wherein the concave groove is symmetrically formed around a central circumferential line on top of the lower ring and has the shape of a circular groove formed over the entire width of top of the lower ring.

4. The method according to claim 2, wherein a distance to the deepest portion of the concave groove from top of the lower ring is 3 to 5 mm, and a length of the deepest portion of the concave groove along the width direction of top of the lower ring is within 70% of the entire width of top of the lower ring.

5. The method according to claim 2, wherein the upper ring has an upper positioning protrusion protruding from the underside thereof, and the lower ring has a lower positioning groove formed on a given portion of top thereof in such a manner as to be coupled to the upper positioning protrusion of the upper ring, the lower positioning groove being formed between an outer center line between the central circumferential line and an outer circumferential line of the lower ring and the outer circumferential line of the lower ring or being formed between an inner center line between the central circumferential line and an inner circumferential line of the lower ring and the inner circumferential line of the lower ring.

6. The method according to claim 5, wherein the lower positioning groove is a hemispherical groove.

7. The method according to claim 1, wherein after the silicon powder as a fusing agent is filled in a fusion portion between the lower ring and the upper ring, the lower ring and the upper ring are mounted on a lower ring fixing device made of molybdenum and an upper ring fixing device made of molybdenum in the silicon part fusion bonding apparatus, respectively.

8. The method according to claim 1, wherein the step of heating and fusing the bonding surfaces of the lower ring and the upper ring comprises the steps of:
forming a vacuum atmosphere of 90 to 110 torr;
injecting argon gas to maintain a vacuum level of 50 to 70 torr;
applying a given pressure to a space between the lower ring and the upper ring by means of the lower ring fixing device and the upper ring fixing device;
operating upper heaters and lower heaters to increase an atmospheric temperature of a vacuum furnace in which a crucible is mounted;
operating side heaters capable of performing high-frequency induction heating to locally heat the fusion portion of the bonding surfaces; and
cooling the fusion portion.

9. The method according to claim 8, wherein a fusing temperature of the fusion portion through the operation of the side heaters capable of performing the high-frequency induction heating is in the range of 1500 to 1600°C.

10. The method according to claim 8, wherein the step of cooling the fusion portion is carried out by turning off the side heaters capable of performing the high-frequency induction heating after the fusion portion has been fused and step by step decreasing the temperatures of the upper heaters and the lower heaters to 1400°C, 1200°C, 1000°C, 900°C, 700°C, 500°C, and 300°C, while the temperature by the respective step being maintained for 10 to 20 minutes.

## Patentansprüche

1. Verfahren zum Verbinden von Siliziumteilen unter Verwendung von Siliziumpulver und einer Hochfrequenzheizvorrichtung, das Verfahren umfassend die Schritte:
Ausbilden konkaver und konvexer Kopplungsflächen auf den Verbindungsflächen eines unteren Rings und eines oberen Rings,
Anbringen des unteren Rings und des oberen Rings auf einer Vorrichtung zum Schmelzschweißen von Siliziumteilen,
Einspritzen von einkristallinem Siliziumpulver in die konkaven und konvexen Kopplungsflächen auf den Verbindungsflächen des unteren Rings und des oberen Rings und
Erhitzen und Verschmelzen der Verbindungsflächen des unteren Rings und des oberen Rings.

2. Verfahren nach Anspruch 1, wobei der Schritt des Ausbildens der konkaven und konvexen Kopplungsflächen auf den Verbindungsflächen des unteren Rings und des oberen Rings durch Ausbilden eines Vorsprungs, der von der Unterseite des oberen Rings vorsteht, und einer konkaven Auskehlung auf der Oberseite des unteren Ring derart durchgeführt wird, dass sie mit dem Vorsprung des oberen Rings gekoppelt wird.

3. Verfahren nach Anspruch 2, wobei die konkave Auskehlung symmetrisch um eine zentrale Umfangslinie an der Oberseite des unteren Rings ausgebildet ist und die Form einer kreisförmigen Auskehlung aufweist, die über die gesamte Breite der Oberseite des unteren Rings ausgebildet ist.

4. Verfahren nach Anspruch 2, wobei der Abstand zum tiefsten Abschnitt der konkaven Auskehlung von der Oberseite des unteren Rings 3 bis 5 mm beträgt und die Länge des tiefsten Abschnitts der konkaven Auskehlung entlang der Breitenrichtung der Oberseite des unteren Rings innerhalb von 70 % der gesamten Breite der Oberkante des unteren Rings beträgt.

5. Verfahren nach Anspruch 2, wobei der obere Ring einen oberen Positionierungsvorsprung aufweist, der von der Unterseite davon hervorsteht, und der untere Ring eine untere Positionierungsauskehlung aufweist, die an einem bestimmten Abschnitt seiner Oberseite derart ausgebildet ist, dass sie mit dem oberen Positionierungsvorsprung des oberen Rings gekoppelt wird, wobei die untere Positionierungsauskehlung zwischen einer äußeren Mittellinie zwischen der zentralen Umfangslinie und einer äußeren Umfangslinie des unteren Rings und der äußeren Umfangslinie des unteren Rings ausgebildet ist oder zwischen einer inneren Mittellinie zwischen der zentralen Umfangslinie und einer inneren Umfangslinie des unteren Rings und der inneren Umfangslinie des unteren Rings ausgebildet ist.

6. Verfahren nach Anspruch 5, wobei die untere Positionierungsauskehlung eine halbkugelförmige Auskehlung ist.

7. Verfahren nach Anspruch 1, wobei nach dem Einfüllen des Siliziumpulvers als Schmelzmittel in einen Schmelzabschnitt zwischen dem unteren Ring und dem oberen Ring der untere Ring und der obere Ring auf einer Befestigungsvorrichtung für den unteren Ring, die aus Molybdän gefertigt ist, bzw. auf einer Befestigungsvorrichtung für den oberen Ring, die aus Molybdän gefertigt ist, in der Vorrichtung zum Schmelzschweißen von Siliziumteilen angebracht werden.

8. Verfahren nach Anspruch 1, wobei der Schritt des Erhitzens und Verschmelzens der Verbindungsflächen des unteren Rings und des oberen Rings die folgenden Schritte umfasst:
Ausbilden einer Vakuumatmosphäre von 90 bis 110 Torr,
Einspritzen von Argongas, um ein Vakuumniveau von 50 bis 70 Torr aufrechtzuerhalten,
Ausüben eines vorgegebenen Drucks auf einen Raum zwischen dem unteren Ring und dem oberen Ring mittels der Befestigungsvorrichtung für den unteren Ring und der Befestigungsvorrichtung für den oberen Ring,
Betreiben von oberen Heizvorrichtungen und unteren Heizvorrichtungen, um die Atmosphärentemperatur eines Vakuumofens zu erhöhen, in dem ein Tiegel untergebracht ist,
Betreiben von seitlichen Heizvorrichtungen, die in der Lage sind, eine Hochfrequenz-Induktionserwärmung auszuführen, um den Schmelzabschnitt der Verbindungsflächen lokal zu erwärmen, und
Abkühlen des Schmelzabschnitts.

9. Verfahren nach Anspruch 8, wobei eine Schmelztemperatur des Schmelzabschnitts durch den Betrieb der seitlichen Heizvorrichtungen, die in der Lage sind, die Hochfrequenz-Induktionserwärmung auszuführen, im Bereich von 1500 bis 1600 °C liegt.

10. Verfahren nach Anspruch 8, wobei der Schritt des Abkühlens des Schmelzabschnitts durch Abschalten der seitlichen Heizvorrichtungen, die in der Lage sind, die Hochfrequenz-Induktionserwärmung auszuführen, nachdem der Schmelzabschnitt geschmolzen wurde, und schrittweises Absenken der Temperaturen der oberen Heizvorrichtungen und der unteren Heizvorrichtungen auf 1400 °C, 1200 °C, 1000 °C, 900 °C, 700 °C, 500 °C und 300 °C, während die Temperatur im jeweiligen Schritt 10 bis 20 Minuten lang aufrechterhalten wird, durchgeführt wird.

## Revendications

1. Procédé de collage de pièces en silicium en utilisant de la poudre de silicium et un dispositif de chauffage à haute fréquence, le procédé comprenant les étapes consistant :
à former des surfaces de couplage concaves et convexes sur les surfaces de collage d'un anneau inférieur et d'un anneau supérieur ;
à monter l'anneau inférieur et l'anneau supérieur sur un appareil de collage par fusion de pièces en silicium ;
à injecter de la poudre de silicium monocristallin dans les surfaces de couplage concaves et convexes se trouvant sur les surfaces de collage de l'anneau inférieur et de l'anneau supérieur ; et
à chauffer et à fusionner les surfaces de collage de l'anneau inférieur et de l'anneau supérieur.

2. Procédé selon la revendication 1, dans lequel l'étape de formation des surfaces de couplage concaves et convexes se trouvant sur les surfaces de collage de l'anneau inférieur et de l'anneau supérieur est réalisée en formant une partie saillante dépassant du dessous de l'anneau supérieur, et en formant une rainure concave sur le dessus de l'anneau inférieur, de manière telle que ladite rainure concave soit couplée à la partie saillante de l'anneau supérieur.

3. Procédé selon la revendication 2, dans lequel la rainure concave est formée symétriquement autour d'une ligne circonférentielle centrale située sur le dessus de l'anneau inférieur et a la forme d'une rainure circulaire formée sur toute la largeur du dessus de l'anneau inférieur.

4. Procédé selon la revendication 2, dans lequel une distance par rapport à la partie la plus profonde de la rainure concave depuis le dessus de l'anneau inférieur est de 3 mm à 5 mm, et une longueur de la partie la plus profonde de la rainure concave, dans le sens de la largeur du dessus de l'anneau inférieur, se situe dans une limite égale à 70 % de toute la largeur du dessus de l'anneau inférieur.

5. Procédé selon la revendication 2, dans lequel l'anneau supérieur a une partie saillante supérieure de positionnement dépassant du dessous dudit anneau supérieur, et l'anneau inférieur a une rainure inférieure de positionnement formée sur une partie donnée du dessus dudit anneau inférieur, de manière telle que ladite rainure inférieure de positionnement soit couplée à la partie saillante supérieure de positionnement de l'anneau supérieur, la rainure inférieure de positionnement étant formée entre une ligne centrale extérieure se trouvant entre la ligne circonférentielle centrale et une ligne circonférentielle extérieure de l'anneau inférieur et la ligne circonférentielle extérieure de l'anneau inférieur, ou bien formée entre une ligne centrale intérieure se trouvant entre la ligne circonférentielle centrale et une ligne circonférentielle intérieure de l'anneau inférieur et la ligne circonférentielle intérieure de l'anneau inférieur.

6. Procédé selon la revendication 5, dans lequel la rainure inférieure de positionnement est une rainure hémisphérique.

7. Procédé selon la revendication 1, dans lequel après que la poudre de silicium servant d'agent de fusion a été remplie dans une partie de fusion se trouvant entre l'anneau inférieur et l'anneau supérieur, l'anneau inférieur et l'anneau supérieur sont montés, respectivement, sur un dispositif de fixation - en molybdène - de l'anneau inférieur et sur un dispositif de fixation - en molybdène - de l'anneau supérieur, lesdits dispositifs se trouvant dans l'appareil de collage par fusion de pièces en silicium.

8. Procédé selon la revendication 1, dans lequel l'étape de chauffage et de fusion des surfaces de collage de l'anneau inférieur et de l'anneau supérieur comprend les étapes consistant :
à former une atmosphère sous vide de 90 à 110 torr ;
à injecter de l'argon gazeux pour maintenir un niveau de vide de 50 à 70 torr ;
à appliquer une pression donnée à un espace compris entre l'anneau inférieur et l'anneau supérieur, ladite pression étant appliquée au moyen du dispositif de fixation de l'anneau inférieur et du dispositif de fixation de l'anneau supérieur ;
à faire fonctionner des réchauffeurs supérieurs et des réchauffeurs inférieurs, afin d'augmenter une température atmosphérique d'un four à vide dans lequel un creuset est monté ;
à faire fonctionner des réchauffeurs latéraux pouvant effectuer un chauffage par induction à haute fréquence, afin de chauffer localement la partie de fusion des surfaces de collage ; et
à refroidir la partie de fusion.

9. Procédé selon la revendication 8, dans lequel une température de fusion de la partie de fusion obtenue sous l'effet du fonctionnement des réchauffeurs latéraux pouvant effectuer le chauffage par induction à haute fréquence est dans la plage comprise entre 1500°C et 1600°C.

10. Procédé selon la revendication 8, dans lequel l'étape de refroidissement de la partie de fusion est réalisée en arrêtant les réchauffeurs latéraux pouvant effectuer le chauffage par induction à haute fréquence, après que la partie de fusion a été fusionnée et après avoir baissé graduellement les températures des réchauffeurs supérieurs et des réchauffeurs inférieurs jusqu'à 1400°C, 1200°C, 1000°C, 900°C, 700°C, 500°C et 300°C, tandis que la température concernant l'étape respective est maintenue pendant 10 à 20 minutes.
